(19) Europäisches Patentamt
European Patent Office
Office européen des brevets

(11) **EP 2 804 229 B1**

(12) **EUROPÄISCHE PATENTSCHRIFT**

(45) Veröffentlichungstag und Bekanntmachung des Hinweises auf die Patenterteilung:
**06.07.2016   Patentblatt 2016/27**

(51) Int Cl.:
*H01L 41/04* *(2006.01)*

(21) Anmeldenummer: **14164766.9**

(22) Anmeldetag: **15.04.2014**

(54) **Schaltung zur bipolaren Ladungsrückgewinnung eines piezoelektrischen Antriebs, Verfahren zur Ansteuerung des Antriebs und mikromechanischer Antrieb**

Circuit for the bipolar charge recovery of a piezoelectric actuator, method for controlling the drive and micro-mechanical drive

Circuit destiné à la récupération de charge bipolaire d'un entraînement piézoélectrique, procédé de commande de l'entraînement et entraînement micro-mécanique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.05.2013   DE 102013208870**

(43) Veröffentlichungstag der Anmeldung:
**19.11.2014   Patentblatt 2014/47**

(73) Patentinhaber: **ROBERT BOSCH GMBH**
**70442 Stuttgart (DE)**

(72) Erfinder:
• **Krayl, Oliver**
**70839 Gerlingen (DE)**
• **Leidich, Stefan**
**71277 Rutesheim (DE)**

(56) Entgegenhaltungen:
**WO-A1-2006/032543     JP-A- H03 289 365
JP-A- 2001 157 472**

EP 2 804 229 B1

## Beschreibung

Stand der Technik

Die vorliegende Erfindung bezieht sich auf eine Schaltung zur bipolaren Ladungsrückgewinnung eines piezoelektrischen Antriebs, auf ein entsprechendes Verfahren zur Ansteuerung der Schaltung sowie auf einen entsprechenden mikromechanischen Antrieb.

Piezoelektrische Antriebe in mikroelektromechanischen Systemen (MEMS) und in makroskopischen Geräten (Gerätetechnik) weisen durch das ladungsgesteuerte Wirkprinzip generell einen Vorteil bezüglich des Leistungsbedarfs auf. Im Gegensatz zu elektromagnetischen Antrieben kann eine statische Kraft ohne Energiezufuhr aufrechterhalten werden.

Piezoelektrische Wandler werden aufgrund der kleinen erzielbaren Auslenkung häufig in mechanischer Resonanz betrieben. Auf diese Weise kann die Amplitude einer Bewegung um Faktoren bis 10.000 erhöht werden. Der Betrieb auf der mechanischen Resonanz erfordert das periodische Umladen der Kapazität. Da der Entladevorgang auf naheliegende Weise ohne externe Leistungszufuhr durch Kurzschluss realisiert werden kann, wird für die periodische Erregung eine entsprechende Leistung benötigt. Die zuvor im Kondensator gespeicherte Energie ist in diesem Fall ebenfalls verloren.

Es sind verschiedene Konzepte bekannt, um die im Kondensator gespeicherte Energie rückzugewinnen. Es ist beispielsweise möglich anstelle einer Entladung mittels Kurzschluss, die geladene Kapazität als Energiequelle zu betrachten und die Energie in einen Zwischenspeicher zu übertragen. Dafür können Schaltwandler verwendet werden mit mehreren Induktivitäten, Dioden und ICs und einem hohen Schaltungsaufwand um diese zu verschalten. Vor allem bei Systemen mit hohen Anforderungen an die Minimierung des Bauraums ist dies problematisch. Es ist zusätzlich zu erwarten, dass aus dem Management der Schaltwandler ein zusätzlicher Leistungsbedarf resultiert, der bei Low Power-Anwendungen den erreichbaren Vorteil verkleinern bzw. neutralisieren kann.

Die DE 10 2010 015 660 A1 beschreibt ein Verfahren zum Schalten einer elektrischen Last in einem Brückenzweig einer Brückenschaltung und eine Brückenschaltung.

Die Veröffentlichung D. Campolo, et. al. "Efficient Charge Recovery Method for Driving Piezoelectric Actuators with Quasi-Square Waves", in IEEE Transactions on Ultrasonics, Ferroelectrics, and Frequency Control", Vol. 50, No.3 (2003) Seiten 237-244 beschreibt ein einfaches Konzept, um in einem Kondensator gespeicherte Energie rückzugewinnen.

Offenbarung der Erfindung

Vor diesem Hintergrund wird mit der vorliegenden Erfindung eine Schaltung zur bipolaren Ladungsrückgewinnung eines piezoelektrischen oder elektrostatischen Antriebs, ein entsprechendes Verfahren zur Ansteuerung der Schaltung sowie ein entsprechender mikromechanischer Antrieb gemäß den Hauptansprüchen vorgestellt. Vorteilhafte Ausgestaltungen ergeben sich aus den jeweiligen Unteransprüchen und der nachfolgenden Beschreibung.

Es wird eine Schaltung zur bipolaren Ladungsrückgewinnung eines piezoelektrischen oder elektrostatischen Antriebs gemäß dem unabhängigen Anspruch 1 vorgestellt.

Eine solche Schaltung ermöglicht das periodische Umladen einer Kapazität mit einer geringen Anzahl elektrischer Bauelemente und möglichst geringen elektrischen Verlusten durch effiziente Ladungsrückgewinnung und "zero-currentswitching", das heißt teilresonantes Schalten im Nulldurchgang des Stromes.

Zur Ansteuerung eines mikromechanischen oder piezoelektrischen oder elektrostatischen Antriebs kann eine entsprechende Schaltung mit einer bipolaren Ladungsrückgewinnung vorgesehen sein. Die Schaltung ist mit einer Spannungsversorgung verbunden. Bei der Spannungsversorgung kann es sich um eine unipolare Stromversorgung handeln. Alternativ kann unter der Spannungsversorgung eine bipolare Spannungsversorgung verstanden werden. Bei dem ersten Anschluss der Spannungsversorgung kann es sich um einen positiven Anschluss und bei dem zweiten Anschluss um einen negativen Anschluss der Spannungsversorgung handeln. Alternativ kann es sich bei dem ersten Anschluss der Spannungsversorgung um einen negativen Anschluss und bei dem zweiten Anschluss um einen positiven Anschluss der Spannungsversorgung handeln. Die Schaltung weist einen Piezo-Aktor auf. Unter dem Piezo-Aktor kann ein Piezo-Element oder ein Piezo verstanden werden. Unter der Spule kann, insbesondere in einem Idealfall ein verlustfreier-Energiespeicher verstanden werden. Unter einer Spule kann eine Induktivität verstanden werden. Die vier Schalter, das heißt der erste Schalter und gleichzeitig oder alternativ der zweite Schalter und gleichzeitig oder alternativ der dritte Schalter und gleichzeitig oder alternativ der vierte Schalter, können ein Schaltungsprinzip eines Vierquadrantenstellers verwenden. Dabei können die vier Schalter in einem Schaltschema zumindest sechs verschiedene Zustände einnehmen. Die Schaltung kann derart ausgebildet sein, dass im Betrieb eine am Piezo-Aktor anliegende Spannung periodisch umgepolt werden kann.

Günstig ist es auch, wenn bei der Schaltung zumindest einer der Schalter als Halbleiterschalter ausgeführt ist. So kann der erste Schalter und gleichzeitig oder alternativ der zweite Schalter und gleichzeitig oder alternativ der dritte Schalter und gleichzeitig oder alternativ der vierte Schalter als Halbleiterschalter ausgeführt sein. So kann die Schaltung günstig und kompakt hergestellt werden.

Um verlustfrei oder nahezu verlustfrei zwischen einzelnen Schaltphasen umschalten zu können, ist eine Bestimmung des Stromflusses im elektrischen Schwingkreis von Vorteil. So kann in eine nächste Schaltphase umgeschaltet werden, wenn durch einen Nulldurchgang ein Umladezyklus als beendet erkannt wird. So kann die Effizienz der Schaltung verbessert oder der Energieverlust minimiert werden. Daher kann der zweite Schalter mit einem Komparator verbunden sein. Alternativ oder gleichzeitig kann der vierte Schalter mit einem weiteren Komparator verbunden sein. Ein entsprechender Komparator kann als ein einfacher Komparator ausgeführt sein. Dabei können der Komparator und der weitere Komparator ausgebildet sein, einen Stromnulldurchgang zu ermitteln. Die Strommessung kann über den Spannungsabfall an dem ohmschen Restwiderstand des Schalters oder eine andere Art der Strommessung erfolgen.

Auch ist es günstig, wenn der Komparator oder der weitere Komparator als ein geschalteter Komparator ausgeführt ist. Wenn ein Spannungsabfall, insbesondere ein auf ein Nullpotenzial bezogener Spannungsabfall in vorbestimmten Schaltphasen freigeschaltet wird, kann ein ermittelter Spannungsabfall immer positiv sein.

Ferner kann bei der Schaltung zumindest einer der Schalter mit einer Ansteuerlogik verbunden sein. So kann beispielsweise der erste Schalter oder alternativ der zweite Schalter oder alternativ der dritte Schalter oder alternativ der vierte Schalter mit der Ansteuerlogik verbunden sein. Die Ansteuerlogik kann ausgebildet sein, den Stromfluss oder Spannungspegel durch entsprechende Schalterstellungen zu beeinflussen beziehungsweise zu steuern. So kann die Ansteuerlogik ausgebildet sein, ein Verfahren zur Ansteuerung einer Schaltung zur Ladungsrückgewinnung eines piezoelektrischen oder elektrostatischen Antriebs, wie dieses nachfolgend ausgeführt ist, auf der Schaltung umzusetzen, und die Schritte des Verfahrens durch entsprechende Schalterstellungen auszuführen.

Günstig ist es auch, wenn die Ansteuerlogik ausgebildet ist, einen Stromnulldurchgang an dem zweiten Schalter und gleichzeitig oder alternativ dem vierten Schalter zu ermitteln. An dem zweiten Schalter und dem vierten Schalter kann ein Nulldurchgang mit einem einfachen Komparator bestimmt werden, da der Spannungsabfall direkt auf das Nullpotenzial bezogen werden kann.

Es wird ein Verfahren zur Ansteuerung einer Schaltung zur bipolaren Ladungsrückgewinnung eines piezoelektrischen oder elektrostatischen Antriebs gemäß dem unabhängigen Anspruch 4 vorgestellt.

Alternativ kann die Schaltphase des Schritts des Umpolens des Piezo-Aktors in eine erste Polarisationsrichtung auch über den ersten und den dritten Schalter erfolgen. So kann der Stromkreis über die negative Versorgungsspannungsschiene oder alternativ über die positive Versorgungsspannungsschiene geführt werden. Wenn der Schritt des Umpolens des Piezo-Aktors in eine erste Polarisationsrichtung über den ersten Schalter und den dritten Schalter erfolgt, so kann dies einem Umpolen der Spannungsversorgung entsprechen. So können dann alle folgenden Schritte auch mit einer umgepolten Spannungsversorgung durchgeführt werden.

Günstig ist es auch, wenn der Schritt des Umpolens des Piezo-Aktors in die erste Polarisationsrichtung, der Schritt des Nachladens des Piezo-Aktors in die erste Polarisationsrichtung, der Schritt des Haltens der ersten Polarisationsrichtung im Piezo-Aktor, der Schritt des Umpolens des Piezo-Aktors in die zweite Polarisationsrichtung, der Schritt des Nachladens des Piezo-Aktors in die zweite Polarisationsrichtung sowie der Schritt des Haltens der zweiten Polarisationsrichtung im Piezo-Aktor wiederholt ausgeführt werden. So kann das Verfahren kontinuierlich ausgeführt werden. Insbesondere kann der piezoelektrische oder elektrostatische Antrieb kontinuierlich betrieben werden. Ferner kann der Schritt des Nachladens des Piezo-Aktors in die erste Polarisationsrichtung ausgeführt werden, nachdem im Schritt des Umpolens des Piezo-Aktors in die erste Polarisationsrichtung am vierten Schalter ein Stromnulldurchgang detektiert wird. Günstig ist es auch, wenn der Schritt des Haltens der ersten Polarisationsrichtung im Piezo-Aktor ausgeführt wird, nachdem im Schritt des Nachladens des Piezo-Aktors in die erste Polarisationsrichtung am vierten Schalter ein Stromnulldurchgang detektiert wird. Ferner kann der Schritt des Nachladens des Piezo-Aktors in die zweite Polarisationsrichtung ausgeführt werden, nachdem im Schritt des Umpolens des Piezo-Aktors in die zweite Polarisationsrichtung am zweiten Schalter ein Stromnulldurchgang detektiert wird. Auch ist es günstig, wenn der Schritt des Haltens der zweiten Polarisationsrichtung im Piezo-Aktor ausgeführt wird, nachdem im Schritt des Nachladens des Piezo-Aktors in die zweite Polarisationsrichtung am zweiten Schalter ein Stromnulldurchgang detektiert wird. Die Reihenfolge der Schritte kann in der Ansteuerlogik hinterlegt sein.

In einer Ausführungsform können vor und gleichzeitig oder alternativ nach dem Schritt des Haltens der ersten Polarisationsrichtung im Piezo-Aktor einzelne Schalter, das heißt der erste Schalter und/oder der zweite Schalter und/oder der dritte Schalter und/oder der vierte Schalter, geschlossen werden oder geschlossen bleiben. Wenn einzelne Schalter geschlossen werden oder geschlossen bleiben, wird zwar kein Stromfluss ermöglicht, aber diese Option kann sinnvoll sein, um einen Schaltungsknoten auf ein definiertes Spannungspotenzial zu bringen, beispielsweise zur Vorbereitung für eine Strommessung, um Umschaltspitzen zu minimieren, oder ähnliches.

Es wird ein mikromechanischer Antrieb zum Antreiben einer Vorrichtung vorgestellt, der eine Schaltung zur bipolaren Ladungsrückgewinnung eines piezoelektrischen oder elektrostatischen Antriebs aufweist.

Die vorliegende Erfindung schafft ferner ein Steuergerät, das ausgebildet ist, um die Schritte einer Variante eines hier vorgestellten Verfahrens in entsprechenden Einrichtungen durchzuführen bzw. umzusetzen. Unter einem Steuergerät kann auch eine Ansteuerlogik verstanden werden. Auch durch diese Ausführungsvariante der Erfindung in Form eines Steuergeräts kann die der Erfindung zugrunde liegende Aufgabe schnell und effizient gelöst werden.

Unter einem Steuergerät kann vorliegend ein elektrisches Gerät verstanden werden, das Sensorsignale verarbeitet und in Abhängigkeit davon Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programmprodukt auf einem Computer einer Vorrichtung oder einem Steuergerät ausgeführt wird.

Die Erfindung wird nachstehend anhand der beigefügten Zeichnungen beispielhaft näher erläutert. Es zeigen:

Fig. 1 einen Schaltplan einer Schaltung zur Ladungsrückgewinnung eines piezoelektrischen Antriebs gemäß dem Stand der Technik;

Fig. 2 eine schematische Darstellung eines Schaltplans einer Schaltung zur Ladungsrückgewinnung eines piezoelektrischen Antriebs gemäß einem Ausführungsbeispiel der vorliegenden Erfindung;

Fig. 3 eine schematische Darstellung eines Schaltplans einer Schaltung zur Ladungsrückgewinnung eines piezoelektrischen Antriebs gemäß einem Ausführungsbeispiel der vorliegenden Erfindung;

Fig. 4 bis Fig. 9 schematische Darstellungen eines Schaltplans einer Schaltung zur Ladungsrückgewinnung eines piezoelektrischen Antriebs mit unterschiedlichen Schalterstellungen gemäß einem Ausführungsbeispiel der vorliegenden Erfindung;

Fig. 10 ein Ablaufdiagramm eines Verfahrens zur Ansteuerung einer Schaltung zur bipolaren Ladungsrückgewinnung eines piezoelektrischen Antriebs gemäß einem Ausführungsbeispiel der vorliegenden Erfindung;

Fig. 11 eine tabellarische Darstellung von Schaltzuständen oder Schaltphasen einer Schaltung zur Ladungsrückgewinnung eines piezoelektrischen Antriebs gemäß einem Ausführungsbeispiel der vorliegenden Erfindung;

Fig. 12 eine grafische Darstellung eines zeitlichen Stromverlaufs einer Schaltung zur bipolaren Ladungsrückgewinnung eines piezoelektrischen Antriebs in einzelnen Schaltphasen gemäß einem Ausführungsbeispiel der vorliegenden Erfindung; und

Fig. 13 eine grafische Darstellung eines zeitlichen Spannungsverlaufs einer Schaltung zur bipolaren Ladungsrückgewinnung eines piezoelektrischen Antriebs in einzelnen Schaltphasen gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

In der nachfolgenden Beschreibung gelten die Ausführungen für einen piezoelektrischen Antrieb auch für einen elektrostatischen Antrieb. Um die Lesbarkeit zu erhöhen, wird in der folgenden Beschreibung der Begriff des elektrostatischen Antriebs als Synonym für einen piezoelektrischen Antrieb oder elektrostatischen Antrieb verwendet.

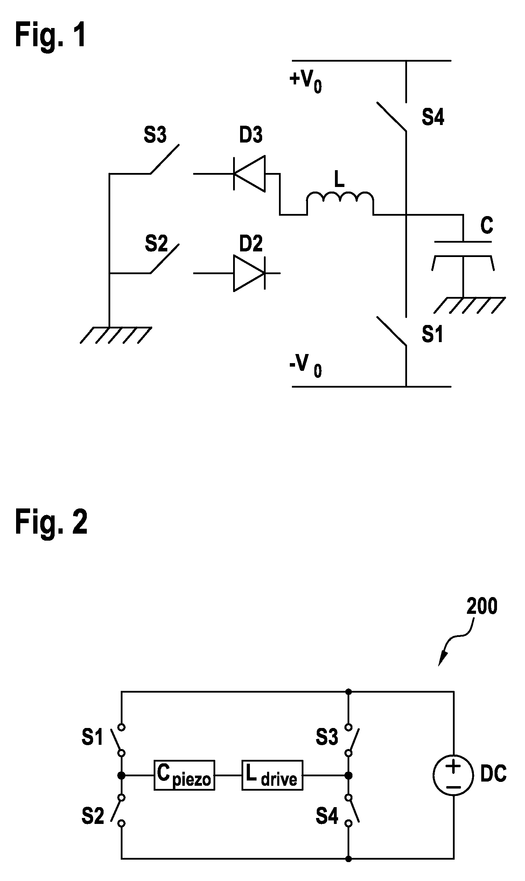

Fig. 1 zeigt einen Schaltplan einfaches Konzept einer Schaltung zur Ladungsrückgewinnung eines piezoelektrischen Antriebs. Dabei wird der piezoelektrische Wandler C anfänglich auf herkömmliche Weise durch Schließen von dem vierten Schalter S4 geladen. Dabei entstehen Energie-Verluste. Piezoelektrische Wandler können vereinfacht als verlustbehaftete Kapazität (Widerstand und Kapazität in Reihenschaltung) modelliert werden. Zur Erzeugung einer Kraft muss die Kapazität aufgeladen werden. Die im Kondensator gespeicherte Energie $E_C$ nach dem Aufladevorgang wird durch

$$E_C = \frac{1}{2}CU^2$$

beschrieben. Die Spannungsquelle muss zur Ladung der Kapazität die Ladung Q liefern. Die von der Quelle abgegebene Energie Es wird durch

$$E_s = QU = CU^2$$

beschrieben. Die Energiedifferenz (50%) wird unabhängig von den Eigenschaften des piezoelektrischen Wandlers und der Spannungsquelle während des Ladevorgangs in Wärme umgesetzt und gilt somit als verloren.

Der Umladevorgang wird jedoch nicht durch dissipatives Entladen und anschließendes Aufladen mittels des ersten Schalters S1 realisiert, sondern durch die Anordnung von Induktivität L, drittem Schalter S3 und erster Diode D3 bzw. Induktivität L, zweitem Schalter S2 sowie zweiter Diode D2. Das Schließen von dem dritten Schalter S3 bei positiv geladenem piezoelektrischem Wandler C führt zu einem Stromanstieg in der Induktivität L. Wären die zweite Diode D2 und die erste Diode D3 nicht vorhanden und alle Bauteile verlustlos, würde eine Schwingung mit der Kreisfrequenz

$$\frac{1}{2\sqrt{(LC)}}$$

resultieren. Die Kapazität C würde periodisch umgeladen werden. Die Funktion von zweiter Diode D2 und erster Diode D3 ist es, den Vorgang zu unterbrechen, wenn der Strom die Richtung wechseln würde. Dies wäre der Fall, wenn der Strom wieder den Wert Null erreicht. Die Polarität der Ladung am Kondensator C ist damit umgekehrt wie zu Begin des Vorgangs. Da zum einen die Dioden D2/D3 einen signifikanten Verlust verursachen und die Induktivität L bzw. Kapazität C ebenfalls nicht als verlustlos betrachtet werden können, ist nach der Umkehr der Polarität die Amplitude der Spannung niedriger als zuvor. Der "Fehlbetrag" der Ladung wird durch die Versorgungsspannungen ausgeglichen. Bei diesem Vorgang fallen wie bei der regulären Ladung der Kapazität C Verluste an.

Fig. 2 zeigt eine schematische Darstellung eines Schaltplans einer Schaltung 200 zur Ladungsrückgewinnung eines piezoelektrischen Antriebs gemäß einem Ausführungsbeispiel der vorliegenden Erfindung. Die Schaltung 200 weist einen Piezo-Aktor $C_{piezo}$, eine Spule $L_{drive}$, vier Schalter S1, S2, S3, S4 sowie eine Spannungsversorgung DC auf. Der Piezo-Aktor $C_{piezo}$ und die Spule $L_{drive}$ sind in Reihe miteinander verbunden. Ein erster Eingang des Piezo-Aktor $C_{piezo}$ ist mit dem ersten Schalter S1 verbunden. Der erste Eingang des Piezo-Aktors $C_{piezo}$ ist ebenso mit dem zweiten Schalter S2 verbunden. Ein erster Eingang der Spule $L_{drive}$ ist mit dem dritten Schalter S3 sowie mit dem vierten Schalter S4 verbunden. Der zweite Eingang des Piezo-Aktors $C_{piezo}$ ist mit dem zweiten Eingang der Spule $L_{drive}$ verbunden. Der erste Schalter S1, der dritte Schalter S3 und der Pluspol der Spannungsversorgung DC sind miteinander verbunden. Weiterhin sind der zweite Schalter S2, der vierte Schalter S4 sowie der Minuspol der Spannungsversorgung DC miteinander verbunden. Die vier Schalter S1, S2, S3 sowie S4 weisen je zwei Anschlüsse auf. In einem aktiven Zustand bzw. geschalteten Zustand sind die zwei Anschlüsse eines Schalters miteinander verbunden. Ansonsten sind die zwei Anschlüsse eines Schalters nicht miteinander verbunden, das heißt, eine Verbindung zwischen den beiden Anschlüssen eines Schalters ist unterbrochen.

In einem nicht gezeigten Ausführungsbeispiel können die Pole der Spannungsversorgung DC vertauscht sein. Somit sind dann der erste Schalter S1, der dritte Schalter S3 und der Minuspol der Spannungsversorgung DC miteinander verbunden. Weiterhin sind in dem nicht gezeigten Ausführungsbeispiel der zweite Schalter S2, der vierte Schalter S4 sowie der Pluspol der Spannungsversorgung DC miteinander verbunden.

Bei dem in Fig. 2 gezeigten Ausführungsbeispiel wird nur eine unipolare Stromversorgung DC benötigt. Eine bipolare (Um-)Ladung mit symmetrischer Amplitude der Spannung wird vorteilhaft ohne eine zusätzliche negative Versorgungsspannung bzw. eine Invertierung der Spannung durch Schaltwandler realisiert. So kann eine effiziente Schaltung mit einer geringen Anzahl an Bauelementen realisiert werden. Dabei wird der Umpolvorgang aktiv durch "zerocurrent switching" gesteuert. Das Ausführungsbeispiel in Fig. 2 unterscheidet sich von der Schaltung in Fig. 1 dadurch, dass die Dioden entfallen und somit keine Verluste an Dioden auftreten können.

Da der Umladevorgang unabhängig von der Güte der Implementierung Verlusten unterliegt, ist es von Vorteil auch den Nachladevorgang ("Auffüllen" der Ladung nach der Umpolung) ebenfalls mittels einer Induktivität $L_{drive}$ zu realisieren. Es kann gezeigt werden, dass der Stromfluss durch eine geeignet dimensionierte Induktivität $L_{drive}$ zu geringeren Verlusten führt, als eine Schaltung nach Fig. 1 erwarten lässt. Der besondere Vorteil des gezeigten Ausführungsbeispiels diesbezüglich resultiert aus der Anordnung der Induktivität $L_{drive}$ in der Schaltung. Die Induktivität $L_{drive}$ ist unabhängig von den Schaltzuständen in Reihenschaltung mit der Kapazität $C_{piezo}$ angeordnet. Dadurch ist nur eine Induktivität $L_{drive}$ erforderlich. Dies stellt einen wesentlichen Vorteil da, da Induktivitäten mit geeigneten elektrischen Eigenschaften generell große Bauelemente sind.

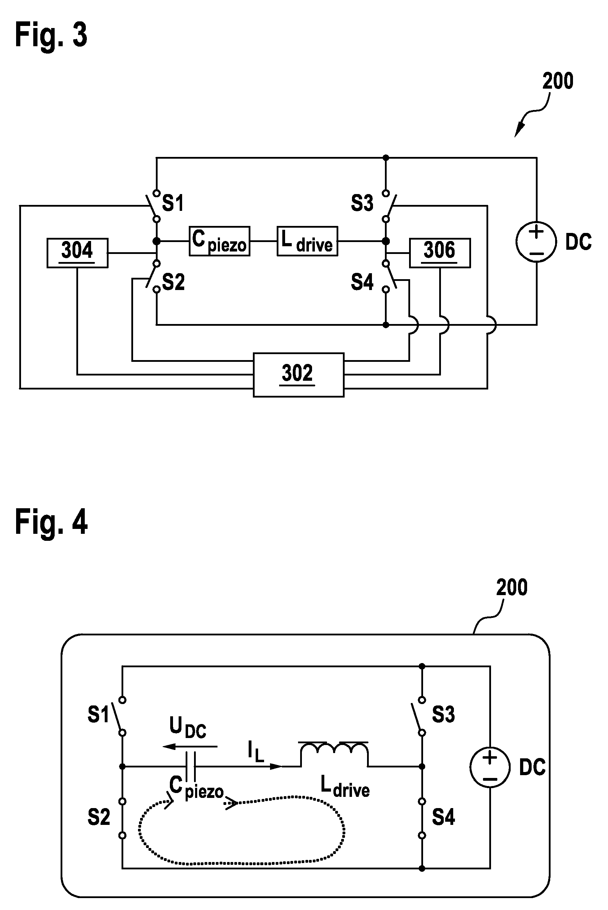

Fig. 3 zeigt eine schematische Darstellung eines Schaltplans einer Schaltung 200 zur Ladungsrückgewinnung eines piezoelektrischen Antriebs gemäß einem Ausführungsbeispiel der vorliegenden Erfindung. Der hier gezeigte Schaltplan 200 entspricht dem in Fig. 2 beschriebenen Schaltplan 200, wobei die vier Schalter S1, S2, S3, S4 mit einer Ansteuerlogik 302 verbunden sind. Weiterhin ist der zweite Schalter S2 mit einem Komparator 304 verbunden. Der vierte Schalter S4 ist mit einem weiteren Komparator 306 verbunden. Der Komparator 304 sowie der weitere Komparator 306 sind mit der Ansteuerlogik 302 verbunden. Der Komparator 304 und gleichzeitig oder alternativ der weitere Komparator 306 sind in einem Ausführungsbeispiel als schaltbarer Komparator ausgeführt.

Wie bereits in der Beschreibung zu Fig. 2 beschrieben, können in einem nicht gezeigten Ausführungsbeispiel die Pole der Spannungsversorgung miteinander vertauscht sein.

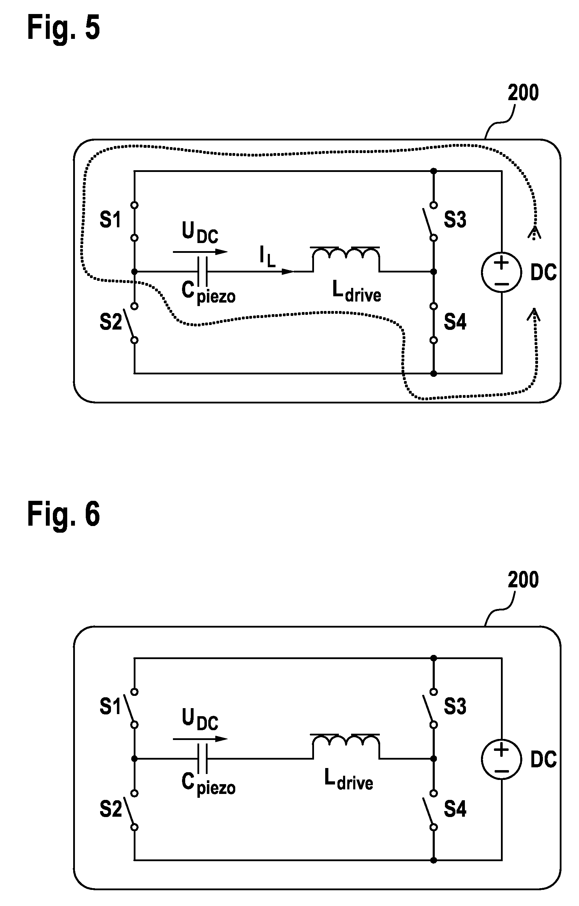

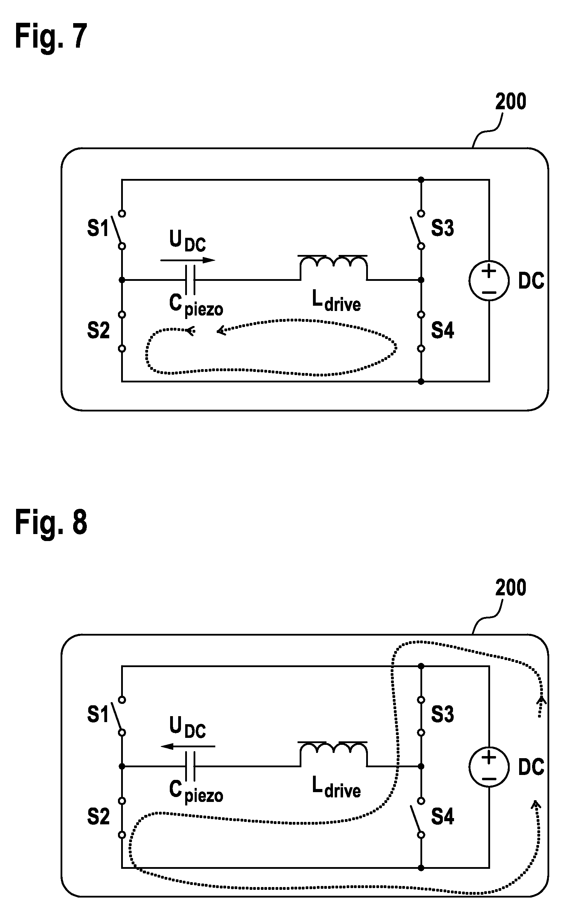

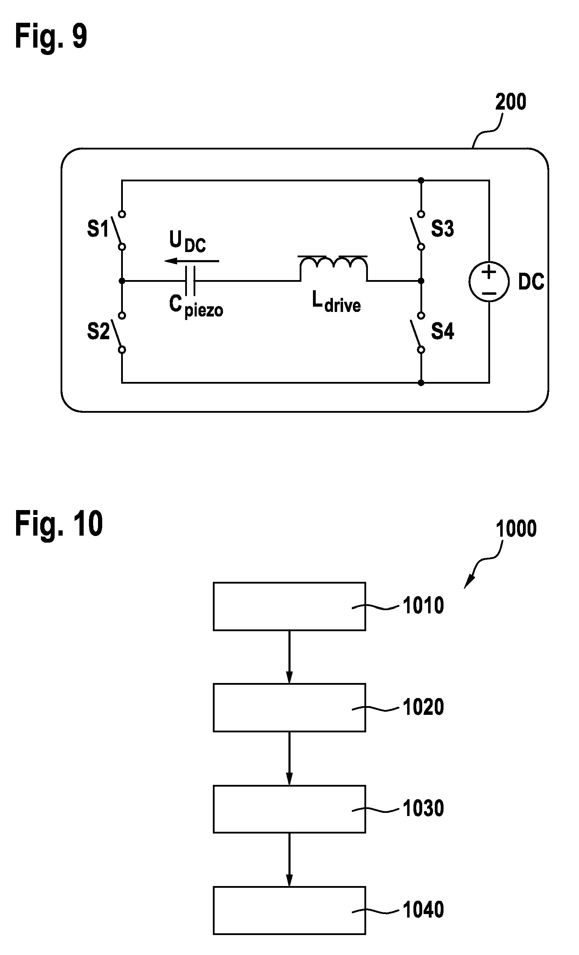

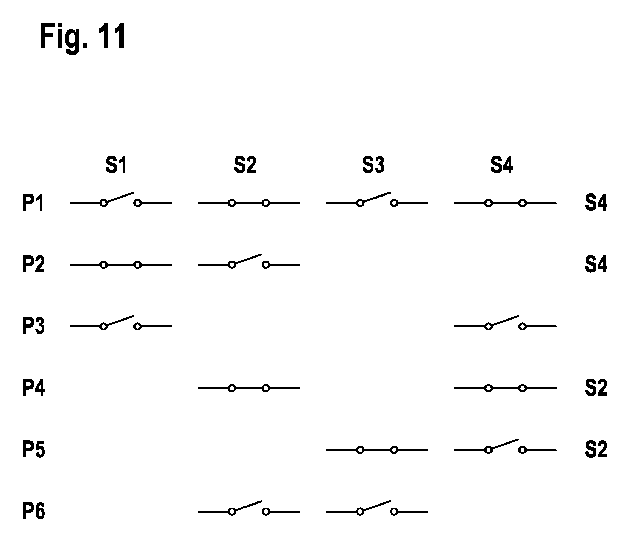

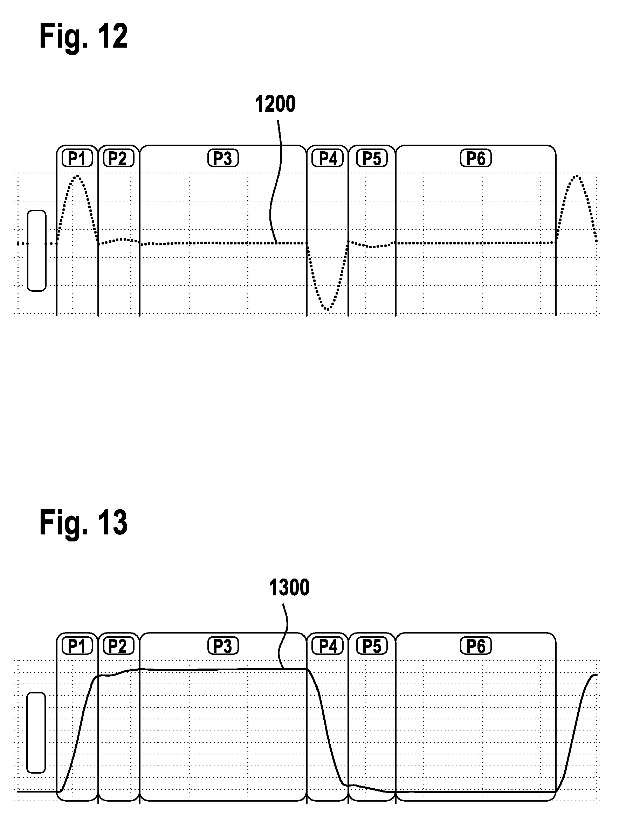

Die Figuren 4 bis 9 zeigen schematische Darstellungen eines Schaltplans einer Schaltung zur Ladungsrückgewinnung eines piezoelektrischen Antriebs mit unterschiedlichen Schalterstellungen gemäß einem Ausführungsbeispiel der vorliegenden Erfindung. Die entsprechenden Schaltzustände sind in der Tabelle in Fig. 11 zusammengefasst. Dabei wird Fig. 4 als erste Phase P1, Fig. 5 als zweite Phase P2, Fig. 6 als dritte Phase P3, Fig. 7 als vierte Phase P4, Fig. 8 als fünfte Phase P5 sowie Fig. 9 als sechste Phase P6 referenziert. Diese Phasen finden sich dann auch in dem zeitlichen Verlauf von Strom und Spannung, wie dieser in Fig. 12 beziehungsweise Fig. 13 wiedergegeben ist. Jeder Phase kann ein Schritt des in Fig. 10 beschriebenen Verfahrens zur Ansteuerung einer Schaltung zur bipolaren Ladungsrückgewinnung eines piezoelektrischen Antriebs zugeordnet werden.

Die Figuren 4 bis 9 zeigen ein grundlegendes Schaltungsprinzip eines Ausführungsbeispiels der vorliegenden Erfindung. Damit die Polarität der Spannung am Piezo-Aktor (Element "$C_{piezo}$") bei unipolarer Spannungsversorgung (Element "DC") gewechselt werden kann, wird das Schaltungsprinzip eines Vierquadrantenstellers verwendet. Der Piezo-Aktor $C_{piezo}$ ist in Serie mit einer Spule geschaltet (Element "$L_{drive}$"), welche (im Idealfall) als verlustfreier Energiezwischenspeicher dient. Wichtig ist dabei, dass die Schwingkreisfrequenz unabhängig von der Betriebsfrequenz des Piezo-Aktors $C_{piezo}$ gewählt werden kann, im Gegensatz zu den bekannten vollresonanten Antriebsmodi. Durch ein Schaltschema mit wenigstens sechs verschiedenen Zuständen (im Folgenden mit Phase 1 bis Phase 6 bezeichnet, etwaige Zusatzphasen mit aktiven Einzelschaltern bleiben unberücksichtigt), kann die am Piezo-Aktor $C_{piezo}$ anliegende Spannung periodisch bei minimalen Energieverlusten umgepolt werden, so wie von der Applikation gefordert.

In den Abbildungen sind zur Vereinfachung die typischerweise verwendeten Halbleiterschalter als vier einfache Schalter dargestellt. In einem Ausführungsbeispiel können die in den Figuren dargestellten Schalter als Halbleiterschalter ausgeführt sein.

Die Abbildungen 4 bis 9 können in einem nicht gezeigten Ausführungsbeispiel auch eine zu der gezeigten Spannungsversorgung invertierte Anordnung des Pluspols und des Minuspols der Spannungsversorgung aufweisen. Ein hierzu analoger Effekt lässt sich durch Schließen beziehungsweise Öffnen der korrespondierenden Schalter erzielen. In der Beschreibung wird ein Piezo-Aktor $C_{piezo}$ beschrieben. Anstelle des Piezo-Aktors kann in einem nicht gezeigten Ausführungsbeispiel auch ein kapazitiver Aktor verwendet werden.

Fig. 4 zeigt eine schematische Darstellung eines Schaltplans einer Schaltung zur Ladungsrückgewinnung eines piezoelektrischen Antriebs, wobei zwei Schalter geöffnet und zwei Schalter geschlossen sind. Bei der Schaltung kann es sich um eine Schaltung, wie diese in Fig. 2 oder Fig. 3 beschrieben wird, handeln. Eine Spule L bzw. eine Induktivität L ist mit einem Piezo-Aktor $C_{piezo}$ verbunden. Der nicht mit der Induktivität L verbundene Anschluss des Piezo-Aktors $C_{piezo}$ ist mit einem ersten Schalter S1 und einem zweiten Schalter S2 verbunden. Der nicht mit dem Piezo-Aktor $C_{piezo}$ verbundene Anschluss der Induktivität $L_{drive}$ ist mit dem dritten Schalter S3 sowie dem vierten Schalter S4 verbunden. Der erste Schalter S1 sowie der dritte Schalter S3 sind mit der Spannungsversorgung DC verbunden. Der zweite Schalter S2 sowie der vierte Schalter S4 sind mit der Spannungsversorgung DC verbunden. Dabei sind der erste Schalter S1 und der dritte Schalter S3 mit dem Pluspol der Spannungsversorgung DC verbunden. Mit dem Minuspol der Spannungsversorgung DC sind der zweite Schalter S2 und der vierte Schalter S4 verbunden.

In einem nicht gezeigten Ausführungsbeispiel wird der Piezo-Aktor $C_{piezo}$ durch einen kapazitiven Aktor ersetzt.

Der Pluspol der Spannungsversorgung DC kann über den geschlossenen ersten Schalter S1 mit dem Piezo-Aktor $C_{piezo}$ verbunden werden. Der Minuspol der Spannungsversorgung DC kann über den geschlossenen zweiten Schalter S2 mit dem Piezo-Aktor $C_{piezo}$ verbunden werden. Über den geschlossenen dritten Schalter S3 kann die Spule $L_{drive}$ mit dem Pluspol der Spannungsversorgung DC verbunden werden. Über den geschlossenen vierten Schalter S4 kann die Spannungsversorgung DC mit der Induktivität $L_{drive}$ verbunden werden.

In dem in Fig. 4 gezeigten Ausführungsbeispiel ist der erste Schalter S1 und der dritte Schalter S3 geöffnet und der zweite Schalter S2 und der vierte Schalter S4 sind geschlossen. Der Piezo-Aktor $C_{piezo}$ ist gemäß dem eingezeichneten Spannungspfeil UDC, das heißt, von der Induktivität $L_{drive}$ in Richtung des ersten bzw. zweiten Schalters S1 bzw. S2 mit der Betriebsspannung aufgeladen. Wie aus Fig. 12 abzulesen ist am Ende der in Fig. 4 gezeigten ersten Phase P1 der Piezo-Aktor $C_{piezo}$ bis auf die ohmschen Verluste nahezu vollständig umgepolt.

Die Darstellung des Schaltplans in Fig. 5 entspricht im Wesentlichen der Darstellung des Schaltplans in Fig. 4, mit dem Unterschied, dass der zweite Schalter S2 geöffnet und der erste Schalter S1 geschlossen ist. Der Schwingkreis aus Piezo-Aktor $C_{piezo}$ und Induktivität $L_{drive}$ wird dadurch in Serie mit der Versorgungsspannungsquelle DC geschaltet und führt eine weitere Stromhalbschwingung mit gleicher Stromrichtung aus. Am Ende der in Fig. 5 gezeigten zweiten Phase P2 ist der Piezo-Aktor $C_{piezo}$ vollständig auf das Potenzial der Spannungsversorgung DC geladen.

Fig. 6 zeigt eine Haltephase des in Fig. 4 und Fig. 5 gezeigten Schaltplans einer Schaltung zur Ladungsrückgewinnung eines piezoelektrischen Antriebs gemäß einem Ausführungsbeispiel der vorliegenden Erfindung. Im Vergleich zu der in Fig. 5 gezeigten zweiten Phase P2 des Nachladens sind alle vier Schalter S1, S2, S3, S4 geöffnet, wodurch kein weiterer Stromfluss möglich ist. In der in Fig. 6 gezeigten Haltephase P3 bleibt die Spannung an dem Piezo-Aktor $C_{piezo}$ erhalten.

Fig. 7 zeigt eine schematische Darstellung eines Schaltplans einer Schaltung zur Ladungsrückgewinnung eines piezoelektrischen Antriebs in der vierten Phase P4 des Umpolens des Piezo-Aktor $C_{piezo}$ in Richtung negativen Vorzeichens. Der zweite Schalter S2 und der vierte Schalter S4 sind geschlossen, der erste Schalter S1 und der dritte Schalter S3 sind geöffnet. So ist ein Schwingkreis aus Piezo-Aktor $C_{piezo}$ und Induktivität $L_{drive}$ geschaltet, wobei der Schwingkreis eine negative Stromhalbschwingung ausführt. Wie aus Fig. 12 ersichtlich ist am Ende der vierten Phase P4 der Piezo-Aktor $C_{piezo}$ bis auf die ohmschen Verluste nahezu vollständig umgepolt. In der nachfolgenden fünften Phase P5 wird der Piezo-Aktor $C_{piezo}$ bis zum Erreichen des Potenzials der Spannungsversorgung DC aufgeladen.

Fig. 8 zeigt eine schematische Darstellung eines Schaltplans einer Schaltung zur Ladungsrückgewinnung eines piezoelektrischen Antriebs in der fünften Phase P5 des Nachladens des Piezo-Aktor $C_{piezo}$ in Richtung negativen Vorzeichens gemäß einem Ausführungsbeispiel der vorliegenden Erfindung. Der vierte Schalter S4 ist geöffnet und der dritte Schalter S3 ist geschlossen im Vergleich zu der in Fig. 7 gezeigten Darstellung der Schaltung 200. Weiterhin ist der erste Schalter S1 geöffnet und der zweite Schalter S2 geschlossen. Der Schwingkreis aus Piezo-Aktor $C_{piezo}$ und Induktivitäten $L_{drive}$ wird in Serie mit der Spannungsversorgung DC geschaltet und führt eine weitere Stromhalbschwingung mit gleicher Stromrichtung aus. Es werden nur die Energieverluste ausgeglichen. Am Ende der fünften Phase P5 ist der Piezo-Aktor $C_{piezo}$ vollständig auf das Potenzial der Spannungsversorgung DC geladen. Es folgt die in Fig. 9 gezeigte sechste Phase P6, welche eine Haltephase darstellt.

Fig. 9 zeigt eine schematische Darstellung eines Schaltplans einer Schaltung zur Ladungsrückgewinnung eines piezoelektrischen Antriebs in der sechsten Phase P5, einer sogenannten Haltephase. In der sechsten Phase P6 sind alle Schalter S1, S2, S3, S4 geöffnet, wodurch kein weiterer Stromfluss in der Schaltung 200 möglich ist. Die Spannung bleibt an dem Piezo-Aktor $C_{piezo}$ erhalten.

Die in Fig. 4 bis Fig. 9 gezeigten sechs Phasen P1, P2, P3, P4, P5, P6 der Schaltung 200 zur Ladungsrückgewinnung eines piezoelektrischen Antriebs wiederholen sich in einem Ausführungsbeispiel zyklisch. Wie nachfolgend beschrieben kann es weitere optionale Phasen geben.

Fig. 10 zeigt ein Ablaufdiagramm eines Verfahrens 1000 zur Ansteuerung einer Schaltung zur bipolaren Ladungsrückgewinnung eines piezoelektrischen Antriebs gemäß einem Ausführungsbeispiel der vorliegenden Erfindung. Bei der Schaltung zur bipolaren Leistungsgewinnung eines piezoelektrischen Antriebs kann es sich um eine entsprechende Schaltung handeln, wie diese in den vorangegangenen Figuren beschrieben wird. So kann in einem Ausführungsbeispiel die Schaltung einen Piezo-Aktor mit einer in Serie zum Piezo-Aktor geschalteten Spule aufweisen, wobei ein erster Anschluss des Piezo-Aktors mit einem ersten Schalter und einem zweiten Schalter verbunden ist, wobei ein erster Anschluss der Spule mit einem dritten Schalter und einem vierten Schalter verbunden ist, wobei ein zweiter Anschluss des Piezo-Aktors mit einem zweiten Anschluss der Spule verbunden ist, wobei der erste Schalter und der dritte Schalter mit einem ersten Anschluss einer Spannungsversorgung verbunden sind, wobei der zweite Schalter und der vierte Schalter mit einem zweiten Anschluss der Spannungsversorgung verbunden sind. Das in Fig. 10 gezeigte Ablaufdiagramm des Verfahrens 1000 weist wenigstens sechs Schritte auf.

In einem Ausführungsbeispiel handelt es sich bei dem ersten Anschluss der Spannungsversorgung um einen positiven Anschluss und bei dem zweiten Anschluss um einen negativen Anschluss. In einem anderen Ausführungsbeispiel handelt es sich bei dem ersten Anschluss der Spannungsversorgung um einen negativen Anschluss und bei dem zweiten Anschluss um einen positiven Anschluss.

Das Verfahren 1000 weist einen Schritt 1010 des Umpolens des Piezo-Aktors in eine erste Polarisationsrichtung auf, wobei der zweite Schalter und der vierte Schalter geschlossen werden, wobei der erste Schalter und der dritte Schalter geöffnet werden. Weiterhin umfasst das Verfahren einen Schritt 1020 des Nachladens des Piezo-Aktors in die erste Polarisationsrichtung, wobei der zweite Schalter geöffnet und der erste Schalter geschlossen wird, wobei der dritte Schalter geöffnet und der vierte Schalter geschlossen bleiben. In einem Schritt 1030 des Haltens der ersten Polarisationsrichtung im Piezo-Aktor werden der erste Schalter und der vierte Schalter geöffnet, wobei der zweite Schalter und der dritte Schalter geöffnet bleiben. In dem darauf folgenden Schritt 1040 des Umpolens des Piezo-Aktors in eine zweite Polarisationsrichtung werden der zweite Schalter und der vierte Schalter geschlossen, wobei der erste Schalter und der dritte Schalter geöffnet bleiben. Darauf wird im Schritt 1050 des Nachladens des Piezo-Aktors in die zweite Polarisationsrichtung der vierte Schalter geöffnet und der dritte Schalter geschlossen, wobei der erste Schalter geöffnet und der zweite Schalter geschlossen bleiben. Im abschließenden Schritt 1060 des Haltens der zweiten Polarisationsrichtung im Piezo-Aktor, wobei der zweite Schalter und der dritte Schalter geöffnet werden, wobei der erste Schalter und der vierte Schalter geöffnet bleiben.

In einem Ausführungsbeispiel werden der Schritt 1010 des Umpolens des Piezo-Aktors in die erste Polarisationsrichtung, der Schritt 1020 des Nachladens des Piezo-Aktors in die erste Polarisationsrichtung, der Schritt 1030 des Haltens der ersten Polarisationsrichtung im Piezo-Aktor, der Schritt 1040 des Umpolens des Piezo-Aktors in die zweite Polarisationsrichtung, der Schritt 1050 des Nachladens des Piezo-Aktors in die zweite Polarisationsrichtung sowie der Schritt 1060 des Haltens der zweiten Polarisationsrichtung im Piezo-Aktor wiederholt ausgeführt.

In einem nicht gezeigten Ausführungsbeispiel können vor und gleichzeitig oder alternativ nach dem Schritt 1030 des Haltens der ersten Polarisationsrichtung im Piezo-Aktor können einzelne Schalter, das heißt der erste Schalter und/oder der zweite Schalter und/oder der dritte Schalter und/oder der vierte Schalter geschlossen werden oder geschlossen bleiben. Wenn einzelne Schalter geschlossen werden oder geschlossen bleiben, wird zwar kein Stromfluss ermöglicht, aber diese Option kann sinnvoll sein, um einen Schaltungsknoten auf ein definiertes Spannungspotenzial zu bringen, beispielsweise zur Vorbereitung für eine Strommessung, um Umschaltspitzen zu minimieren, oder ähnliches. Dies gilt in einem nicht gezeigten Ausführungsbeispiel analog auch für den Schritt 1060 des Haltens der zweiten Polarisationsrichtung.

Fig. 11 zeigt eine tabellarische Darstellung von Schaltzuständen oder Schaltphasen einer Schaltung zur Ladungsrückgewinnung eines piezoelektrischen Antriebs gemäß einem Ausführungsbeispiel der vorliegenden Erfindung. Bei der Schaltung zur Ladungsrückgewinnung eines piezoelektrischen Antriebs kann es sich um eine in Fig. 2 bis Fig. 9 gezeigte Schaltung handeln. Die Tabelle weist sieben Zeilen und sechs Spalten auf. In der ersten Zeile werden die vier Schalter S1, S2, S3, S4 bezeichnet. So wird in der zweiten Spalte der erste Schalter S1 dargestellt, in der dritten Spalte wird der zweite Schalter S2 dargestellt, in der vierten Spalte wird der dritte Schalter S3 und in der fünften Spalte wird der vierte Schalter S4 dargestellt. Die zweite Zeile beschreibt die Schaltzustände während der ersten Phase P1. Hierbei ist der erste Schalter S1 geöffnet, der zweite Schalter S2 geschlossen, der dritte Schalter S3 geöffnet und der vierte Schalter S4 geschlossen. In der dritten Zeile sind die Schaltzustände der vier Schalter während der zweiten Phase P2 dargestellt. Im Unterschied zur ersten Phase P1 ist der erste Schalter S1 geschlossen und der zweite Schalter S2 geöffnet. Unverändert zur ersten Phase P1 ist der dritte Schalter S3 geöffnet und der vierte Schalter S4 geschlossen. In der dritten Phase P3 ist im Unterschied zur zweiten Phase P2 der erste Schalter S1 und der vierte Schalter S4 geöffnet. Der zweite Schalter S2 sowie der dritte Schalter S3 sind unverändert geöffnet. In der vierten Phase P4 sind im Unterschied zur dritten Phase P3 der zweite Schalter S2 und der vierte Schalter S4 geschlossen. Der erste Schalter S1 sowie der dritte Schalter S3 sind in der vierten Phase P4 im Vergleich zur dritten Phase P3 unverändert geöffnet. In der fünften Phase P5 sind der dritte Schalter S3 geschlossen sowie der vierte Schalter S4 geöffnet. Unverändert zur vierten Phase P4 sind in der fünften Phase P5 der erste Schalter S1 geöffnet sowie der zweite Schalter S2 geschlossen. In der sechsten Phase P6 sind alle vier Schalter geöffnet, sodass im Unterschied zur fünften Phase P5 der zweite Schalter S2 und der dritte Schalter S3 geöffnet werden müssen.

In einem Ausführungsbeispiel kann sich an die sechste Phase P6 die erste Phase P1 anschließen und die Schaltzustände können erneut durchlaufen werden.

In einem nicht gezeigten Ausführungsbeispiel können zwischen den einzelnen Phasen P1, P2, P3, P4, P5, P6 noch Zwischenphasen eingeschoben werden. So kann durch Schließen eines Schalters oder geschlossen halten eines Schalters ein Schaltungsknoten auf ein definiertes Spannungspotenzial gebracht werden. Insbesondere vor und gleichzeitig oder alternativ nach der dritten Phase P3 und gleichzeitig oder alternativ der sechsten Phase P6 können derartige Zwischenphasen von Vorteil sein. Diese Zwischenphasen können als Potenzialausgleichsphasen bezeichnet werden.

Fig. 12 zeigt eine grafische Darstellung eines zeitlichen Stromverlaufs 1200 einer Schaltung zur bipolaren Ladungsrückgewinnung eines piezoelektrischen Antriebs in einzelnen Schaltphasen gemäß einem Ausführungsbeispiel der vorliegenden Erfindung. In einem kartesischen Koordinatensystem ist auf der Abszisse die Zeit und auf der Ordinate die Stromstärke in aufgetragen. Der zeitliche Verlauf ist in sechs Phasen P1, P2, P3, P4, P5, P6 unterteilt. Die Kurve des Stromverlaufs 1200 stellt beispielsweise den Strom durch den in Fig. 4 bis Fig. 9 gezeigten Piezo-Aktor $C_{piezo}$ dar. Die Kurve des Stromverlaufs 1200 beginnt bei 0, wenn es in die erste Phase P1 geht. In der ersten Phase P1 steigt die Kurve nahezu auf den Maximalwert und sinkt dann wieder auf einen Wert von 0 ab. Der Kurvenverlauf entspricht näherungsweise einer, insbesondere gedämpften, Sinushalbwelle, wie er bei einem gedämpften Serienschwingkreis entsteht. Am Ende der ersten Phase P1 ist ein Nulldurchgang zu erkennen. In der zweiten Phase steigt die Stromstärke nur leicht an, da nur die Umladeverluste ausgeglichen werden, und fällt wieder auf Null zurück. In der dritten Phase P3 fließt kein Strom durch den Piezo-Aktor $C_{piezo}$. Die vierte Phase P4 entspricht weitgehend der ersten Phase P1 mit umgekehrten Vorzeichen. Von dem Ausgangswert bei 0 mA geht die Kurve des Stromverlaufs 1200 in der vierten Phase P4 auf nahezu dem negativem Maximalwert um dann wieder auf den Ausgangswert von Null zurückzugehen. Die fünfte Phase P5 entspricht weitgehend der zweiten Phase P2 mit umgekehrten Vorzeichen. Von dem Ausgangswert bei 0 mA geht die Kurve des Stromverlaufs 1200 in der fünften Phase nur auf einen kleinen Wert, da auch hier wieder nur die Umladeverluste ausgeglichen werden müssen, um dann wieder auf den Ausgangswert von 0 zurückzugehen. In der sechsten Phase fließt kein Strom durch den Piezo-Aktor $C_{piezo}$.

In einem nicht gezeigten Ausführungsbeispiel können die in der Beschreibung zu Fig. 11 dargestellten Potenzialausgleichsschaltphasen an den Übergängen zwischen den einzelnen Phasen eingeschoben sein.

Der Übergang von den einzelnen Phasen ist durch einen Stromnulldurchgang an dem zweiten Schalter S2 oder alternativ dem vierten Schalter S4 gekennzeichnet. Hierbei wird auf die in den Figuren Fig. 4 bis Fig. 9 gezeigte Schaltung verwiesen. Die im Folgenden genannten Schritte beziehen sich auf das in Fig. 10 beschriebene Verfahren. Der Schritt des Nachladens des Piezo-Aktors $C_{piezo}$ in die erste Polarisationsrichtung wird ausgeführt, nachdem im Schritt des Umpolens des Piezo-Aktors in die erste Polarisationsrichtung am vierten Schalter S4 ein Stromnulldurchgang detektiert wird. Der Schritt des Haltens der ersten Polarisationsrichtung im Piezo-Aktor wird ausgeführt, nachdem im Schritt des Nachladens des Piezo-Aktors in die erste Polarisationsrichtung am vierten Schalter ein Stromnulldurchgang detektiert wird. Der Schritt des Nachladens des Piezo-Aktors in die zweite Polarisationsrichtung wird ausgeführt, nachdem im Schritt des Umpolens des Piezo-Aktors in die zweite Polarisationsrichtung am zweiten Schalter ein Stromnulldurchgang detektiert wird. Der Schritt des Haltens der zweiten Polarisationsrichtung im Piezo-Aktor wird ausgeführt, nachdem im Schritt des Nachladens des Piezo-Aktors in die zweite Polarisationsrichtung am zweiten Schalter ein Stromnulldurchgang detektiert wird. Mit anderen Worten wird von der ersten Phase P1 in die zweite Phase P2 gewechselt, wenn am vierten Schalter S4 ein Stromnulldurchgang detektiert wird. Von der zweiten Phase P2 in die dritte Phase P3 wird gewechselt, wenn am vierten Schalter S4 ein Stromnulldurchgang detektiert wird. Der Wechsel von der vierten Phase P4 in die fünfte Phase P5 wird vollzogen, wenn am zweiten Schalter S2 ein Stromnulldurchgang detektiert wird. Auch der Wechsel von der fünften Phase P5 in die sechste Phase P6 wird durch einen am zweiten Schalter S2 detektierten Stromnulldurchgang charakterisiert. Die folgende Figur zeigt den gleichen zeitlichen Verlauf für die Spannung an dem Piezo-Aktor $C_{piezo}$.

Fig. 13 zeigt eine grafische Darstellung eines zeitlichen Spannungsverlaufs 1300 einer Schaltung zur bipolaren Ladungsrückgewinnung eines piezoelektrischen Antriebs in einzelnen Schaltphasen gemäß einem Ausführungsbeispiel der vorliegenden Erfindung. In einem kartesischen Koordinatensystem ist der Spannungsverlauf 1300 beispielsweise einer in den Figuren 4 bis 9 gezeigten Schaltung dargestellt. Dabei ist der Spannungsverlauf 1300 in sechs Phasen P1, P2, P3, P4, P5, P6 unterteilt, wie sich diese beispielsweise durch die sechs Schritte des in Fig. 10 dargestellten Verfahrens ergeben. Dabei kann der in Fig. 13 dargestellt Spannungsverlauf 1300 mit dem in Fig. 12 dargestellten Stromverlauf gemeinsam gelesen werden. Auf der Ordinate ist eine Spannung aufgetragen. Auf der Abszisse ist die Zeit in aufgetragen.

Vor Eintritt in die erste Phase P1 sei Cpiezo auf den negativen Maximalwert geladen. In der ersten Phase erfolgt die Umladung auf beinahe den maximalen Positiven Spannungswert (abzüglich der Umladeverluste). In der zweiten Phase P2 werden die Umladeverluste ausgeglichen und die Spannung steigt auf den positiven Maximalwert an. In der dritten Phase P3 bleibt die Spannung konstant auf dem am Ende der zweiten Phase P2 erreichten Wert. Die vierte Phase P4 bis sechste Phase P6 entsprechen den ersten drei Phasen P1, P2, P3 mit umgekehrten Vorzeichen. So fällt in der vierten Phase P4 die Spannung auf einen Wert knapp unterhalb des maximal möglichen negativen Maximalwertes (abzüglich der Umladeverluste), um dann in der fünften Phase P5 weiter auf mit dem Ausgleich der Umladeverluste auf den maximal möglichen negativen Spannungswert zu sinken. In der sechsten Phase P6 bleibt die Spannung konstant auf diesem Wert. Nach der sechsten Phase P6 ist eine weitere erste Phase P1 angedeutet dem Beginn eines weiteren Umladevorgangs in positiver Spannungsrichtung.

Die erste Phase P1 und die vierte Phase P4 benötigen die halbe Periodendauer eines gedämpften Serienschwingkreises, ebenso wie die Nachladephasen, die zweite Phase P2 und die fünfte Phase P5. Die Dauer der Haltephasen P3 und P6 ist frei wählbar.

Im Folgenden werden die einzelnen Schaltphasen an einem Ausführungsbeispiel erläutert, wobei neben den in Fig. 4 bis Fig. 9 dargestellten Schaltplänen auf den Stromverlauf in Fig. 12 und den Spannungsverlauf in Fig. 13 verwiesen wird. Die einzelnen Schaltphasen P1, P2, P3, P4, P5, P6 sind in der Titelzeile in Fig. 12 und Fig. 13 hinterlegt um eine einfache Zuordnung zu ermöglichen.

In der ersten Phase P1 wird der Piezo-Aktor $C_{piezo}$ in Richtung positiven Vorzeichens umgepolt - siehe Fig. 4. Im Startzustand sei der Piezo-Aktor $C_{piezo}$ gemäß dem Spannungspfeil mit der Betriebsspannung $U_{DC}$ aufgeladen. Die beiden Schalter S2 und S4 werden geschlossen, Schalter S1 und S3 werden geöffnet. Dadurch wird der Schwingkreis aus Piezo-Aktor $C_{piezo}$ und Spule $L_{drive}$ geschaltet, welcher dann eine positive Stromhalbschwingung ausführt. Am Ende von der ersten Phase P1 ist Piezo-Aktor $C_{piezo}$ bis auf die ohmschen Verluste nahezu vollständig umgepolt.

In der zweiten Phase P2 wird der Piezo-Aktor $C_{piezo}$ nachgeladen, in Richtung positiven Vorzeichens - siehe Fig. 5. Der Schalter S2 wird geöffnet und S1 geschlossen, die Schalterstellung von S3 und S4 bleibt erhalten. Der Schwingkreis aus Piezo-Aktor $C_{piezo}$ und Spule $L_{drive}$ wird dadurch in Serie mit der Versorgungsspannungsquelle DC geschaltet. Der Schwingkreis aus Piezo-Aktor $C_{piezo}$ und Spule $L_{drive}$ führt eine weitere Stromhalbschwingung mit gleicher Stromrichtung, aber viel kleinerer Amplitude aus, da nur die ohmschen Verluste ausgeglichen werden müssen. Am Ende von der zweiten Phase P2 ist Piezo-Aktor $C_{piezo}$ nun vollständig auf das Potenzial der Versorgungsspannungsquelle DC geladen.

Die dritte Phase P3 beschreibt eine Haltephase des Piezo-Aktors $C_{piezo}$ Haltephase, positiv geladen - siehe Fig. 6. Alle Schalter S1 bis S4 werden geöffnet, dadurch kein weiterer Stromfluss. Die Spannung an Piezo-Aktor $C_{piezo}$ bleibt erhalten.

In der vierten Phase P4 wird der Piezo-Aktor $C_{piezo}$ umgepolt in Richtung negativen Vorzeichens - siehe Fig. 7. Die beiden Schalter S2 und S4 werden geschlossen, die Schalter S1 und S3 bleiben geöffnet. Dadurch wird der Schwingkreis aus Piezo-Aktor $C_{piezo}$ und Spule $L_{drive}$ geschaltet, welcher nun eine negative Stromhalbschwingung ausführt. Am Ende von der vierten Phase P4 ist Piezo-Aktor $C_{piezo}$ bis auf die ohmschen Verluste nahezu vollständig umgepolt.

In der fünften Phase P5 wird Piezo-Aktor $C_{piezo}$ in Richtung negativen Vorzeichens nachgeladen - siehe Fig. 8. Der Schalter S4 wird geöffnet und S3 geschlossen, die Schalterstellung von S1 und S2 bleibt erhalten. Der Schwingkreis aus Piezo-Aktor $C_{piezo}$ und Spule $L_{drive}$ wird dadurch in Serie mit der Versorgungsspannungsquelle DC geschaltet. Der Schwingkreis aus Piezo-Aktor $C_{piezo}$ und Spule $L_{drive}$ führt eine weitere Stromhalbschwingung mit gleicher Stromrichtung, aber viel kleinerer Amplitude aus, da nur die Energieverluste ausgeglichen werden müssen. Am Ende von der fünften Phase P5 ist Piezo-Aktor $C_{piezo}$ nun vollständig auf das Potenzial der Versorgungsspannungsquelle DC geladen.

Die sechste Phase P6 beschreibt eine Haltephase des Piezo-Aktor $C_{piezo}$, negatives Vorzeichen - siehe Fig. 9. Alle Schalter S1 bis S4 werden geöffnet, dadurch kein weiterer Stromfluss. Die Spannung an Piezo-Aktor $C_{piezo}$ bleibt erhalten. Danach beginnt der Schaltzyklus wieder bei der ersten Schaltphase P1.

In den Schaltphasen P1, P2, P4 und P5 ist der elektrische Schwingkreis, bestehend aus Piezo-Aktor $C_{piezo}$ und Spule $L_{drive}$ jeweils für eine Halbperiode aktiv. Weiterhin seien alle dissipativen Elemente zu einem Verlustwiderstand Rdiss zusammengefasst, dann ergibt sich die folgende Zeitdauer

$$T_{phase} = \pi \left/ \sqrt{\frac{1}{L_{drive} \cdot C_{piezo}} - \frac{R_{diss}^2}{4 \cdot L_{drive}^2}} \right.$$

Diese Zeitdauer, die der halben Zeitdauer gemäß der Schwingungsgleichung eines gedämpften Serienschwingkreises entspricht, muss möglichst exakt eingehalten werden, um verlustfrei im Stromnulldurchgang zur nächsten Schaltphase umschalten zu können. Dies wird im englischen Sprachgebrauch: "Zero Current Switching", kurz ZCS, genannt.

In der Praxis kann diese Zeitdauer meist nicht fest gewählt werden, da a priori die Bauteiletoleranzen und die Kreisverluste nicht bekannt sind. Weiterhin werden sich die Bauteilewerte über die Temperatur ändern und alle Piezomaterialien haben mehr oder weniger ausgeprägte nichtlineare Eigenschaften (Hysterese, Eigenkapazität ändert sich mit der angelegten Spannung usw.). Gemäß einem Ausführungsbeispiel wird daher eine Ansteuerlogik eingesetzt, welche den Stromnulldurchgang im laufenden Betrieb erkennt und ein Weiterschalten in die nächste Schaltphase erst zulässt, wenn ein Umladezyklus abgeschlossen ist. Durch Analysieren des Stromflusses durch die einzelnen Schalter während der Schaltphasen lässt sich erkennen, dass es am sinnvollsten sein kann a) den Stromnulldurchgang im Schaltelement S4 in den Umladephasen 1 und 2 und b) den Stromnulldurchgang im Schaltelement S2 in den Umladephasen 4 und 5 zu ermitteln.

Ein vorgestelltes Ausführungsbeispiel bietet die im Folgenden beschriebenen Vorteile. So wird zur Strommessung kein zusätzliches Bauteil benötigt, es kann der immer vorhandene ohmsche Spannungsabfall an dem entsprechenden Schaltelement, insbesondere am zweiten Schalter S2 und am vierten Schalter S4, genutzt werden. Der absolute Wert dieser Spannung ist dabei völlig unwichtig, es muss lediglich der Nulldurchgang des Stromes erkannt werden. Folglich sind die sicherlich vorhandenen Variationen des Schalterwiderstandes durch Bauteiletoleranzen, Temperatur usw. völlig irrelevant. Weiterhin ist der Spannungsabfall direkt auf das Nullpotenzial bezogen, das heißt es genügt ein einfacher Komparator zur Nulldurchgangsdetektion.

Wenn die Nulldurchgangsdetektion an dem hochgesetzten ersten Schalter S1 und drittem Schalter S3 ermittelt würde, wäre eine Differenzstufe erforderlich, auf die in dem in Fig. 2 beschriebenen Ausführungsbeispiel verzichtet werden kann.

Weiterhin ist der an dem zweiten Schalter S2 und an dem vierten Schalter S4 ermittelte Spannungsabfall immer positiv, wenn der entsprechende Komparator nur in der richtigen Schaltphase freigeschaltet wird ("Gated Comparator"). Das heißt, der Komparator für den zweiten Schalter S2 ist nur in den Schaltphasen P4 und P5 aktiv und der Komparator für den vierten Schalter S4 nur in den Schaltphasen P1 und P2 aktiv geschaltet wird. Ein geschalteter Komparator bedeutet schaltungstechnisch so gut wie keinen Zusatzaufwand.

In einem Ausführungsbeispiel verfügt der Komparator über einen Freischalteingang.

Ein Ausführungsbeispiel kann aufgrund seiner kleinen Bauform ideal für mobile Applikationen eingesetzt werden. Vorteilhaft weist ein Ausführungsbeispiel einen geringen Energiebedarf auf. Mit einem Ausführungsbeispiel kann eine periodische Schwingung mit Piezoantrieb realisiert werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

**Patentansprüche**

1. Schaltung (200) zur bipolaren Ladungsrückgewinnung eines piezoelektrischen oder elektrostatischen Antriebs, bei dem ein Piezo-Element ($C_{piezo}$) mit einer Spule ($L_{drive}$) in Serie geschaltet ist, wobei ein erster Anschluss des Piezo-Elements ($C_{piezo}$) mit einem ersten Schalter (S1) und einem zweiten Schalter (S2) verbunden ist, wobei ein erster Anschluss der Spule ($L_{drive}$) mit einem dritten Schalter (S3) und einem vierten Schalter (S4) verbunden ist, wobei ein zweiter Anschluss des Piezo-Elements ($C_{piezo}$) mit einem zweiten Anschluss der Spule ($L_{drive}$) verbunden ist, wobei der erste Schalter (S1) und der dritte Schalter (S3) mit einem ersten Anschluss einer Spannungsversorgung (DC) verbunden sind, und wobei der zweite Schalter (S2) und der vierte Schalter (S4) mit einem zweiten Anschluss der Spannungsversorgung (DC) verbunden sind, **dadurch gekennzeichnet, dass** der zweite Schalter (S2) mit einem Komparator (304) verbunden ist, der ausgebildet ist, einen Stromnulldurchgang an dem zweiten Schalter (S2) zu ermitteln, und der vierte Schalter (S4) mit einem weiteren Komparator (306) verbunden ist, der ausgebildet ist, einen Stromnulldurchgang an dem vierten Schalter (S4) zu ermitteln, und/oder zumindest einer der Schalter (S1, S2, S3, S4) mit einer Ansteuerlogik (302) verbunden ist, die ausgebildet ist, den Stromnulldurchgang an dem zweiten Schalter (S2) und dem vierten Schalter (S4) zu ermitteln.

2. Schaltung (200) gemäß Anspruch 1, bei der zumindest einer der Schalter (S1, S2, S3, S4) als Halbleiterschalter ausgeführt ist.

3. Schaltung (200) gemäß einem der vorangegangenen Ansprüche, bei der der Komparator (304) und/oder der weitere Komparator (306) als ein geschalteter Komparator ausgeführt ist.

4. Verfahren (1000) zur Ansteuerung einer Schaltung (200) zur bipolaren Ladungsrückgewinnung eines piezoelektrischen oder elektrostatischen Antriebs, wobei die Schaltung (200) einen Piezo-Element ($C_{piezo}$) mit einer in Serie zum Piezo-Element ($C_{piezo}$) geschalteten Spule ($L_{drive}$) aufweist, wobei ein erster Anschluss des Piezo-Elements ($C_{piezo}$) mit einem ersten Schalter (S1) und einem zweiten Schalter (S2) verbunden ist, wobei ein erster Anschluss der Spule ($L_{drive}$) mit einem dritten Schalter (S3) und einem vierten Schalter (S4) verbunden ist, wobei ein zweiter Anschluss des Piezo-Elements ($C_{piezo}$) mit einem zweiten Anschluss der Spule ($L_{drive}$) verbunden ist, wobei der erste Schalter (S1) und der dritte Schalter (S3) mit einem ersten Anschluss einer Spannungsversorgung (DC) verbunden sind, und wobei der zweite Schalter (S2) und der vierte Schalter (S4) mit einem zweiten Anschluss der Spannungsversorgung (DC) verbunden sind, wobei das Verfahren (1000) die folgenden Schritte aufweist:

Umpolen (1010) des Piezo-Elements ($C_{piezo}$) in eine erste Polarisationsrichtung, wobei der zweite Schalter (S2) und der vierte Schalter (S4) geschlossen werden, und wobei der erste Schalter (S1) und der dritte Schalter (S3) geöffnet werden;
Nachladen (1020) des Piezo-Elements (Cpiezo) in die erste Polarisationsrichtung, wobei der zweite Schalter (S2) geöffnet und der erste Schalter (S1) geschlossen wird, und wobei der dritte Schalter (S3) geöffnet und der vierte Schalter (S4) geschlossen bleiben;
Halten (1030) der ersten Polarisationsrichtung im Piezo-Element ($C_{piezo}$), wobei der erste Schalter (S1) und der vierte Schalter (S4) geöffnet werden, und wobei der zweite Schalter (S2) und der dritte Schalter (S3) geöffnet bleiben;
Umpolen (1040) des Piezo-Elements ($C_{piezo}$) in eine zweite Polarisationsrichtung, wobei der zweite Schalter (S2) und der vierte Schalter (S4) geschlossen werden, und wobei der erste Schalter (S1) und der dritte Schalter (S3) geöffnet bleiben;
Nachladen (1050) des Piezo-Elements ($C_{piezo}$) in die zweite Polarisationsrichtung, wobei der vierte Schalter (S4) geöffnet und der dritte Schalter (S3) geschlossen wird, und wobei der erste Schalter (S1) geöffnet und der zweite Schalter (S2) geschlossen bleiben; und
Halten (1060) der zweiten Polarisationsrichtung im Piezo-Element ($C_{piezo}$), wobei der zweite Schalter (S2) und der dritte Schalter (S3) geöffnet werden, und wobei der erste Schalter (S1) und der vierte Schalter (S4) geöffnet bleiben,
**dadurch gekennzeichnet, dass**
der Schritt (1020) des Nachladens des Piezo-Elements ($C_{piezo}$) in die erste Polarisationsrichtung ausgeführt wird, nachdem im Schritt (1010) des Umpolens des Piezo-Elements ($C_{piezo}$) in die erste Polarisationsrichtung am vierten Schalter (S4) ein Stromnulldurchgang detektiert wird,

bei dem der Schritt (1030) des Haltens der ersten Polarisationsrichtung im Piezo-Element ($C_{piezo}$) ausgeführt wird, nachdem im Schritt (1020) des Nachladens des Piezo-Elements ($C_{piezo}$) in die erste Polarisationsrichtung am vierten Schalter (S4) ein Stromnulldurchgang detektiert wird,

bei dem der Schritt (1050) des Nachladens des Piezo-Elements ($C_{piezo}$) in die zweite Polarisationsrichtung ausgeführt wird, nachdem im Schritt (1040) des Umpolens des Piezo-Elements ($C_{piezo}$) in die zweite Polarisationsrichtung am zweiten Schalter (S2) ein Stromnulldurchgang detektiert wird, und

bei dem der Schritt (1060) des Haltens der zweiten Polarisationsrichtung im Piezo-Element ($C_{piezo}$) ausgeführt wird, nachdem im Schritt (1050) des Nachladens des Piezo-Elements ($C_{piezo}$) in die zweite Polarisationsrichtung am zweiten Schalter (S2) ein Stromnulldurchgang detektiert wird..

5. Verfahren (1000) gemäß Anspruch 4, bei dem der Schritt (1010) des Umpolens des Piezo-Elements ($C_{piezo}$) in die erste Polarisationsrichtung, der Schritt (1020) des Nachladens des Piezo-Elements ($C_{piezo}$) in die erste Polarisationsrichtung, der Schritt (1030) des Haltens der ersten Polarisationsrichtung im Piezo-Element ($C_{piezo}$), der Schritt (1040) des Umpolens des Piezo-Elements ($C_{piezo}$) in die zweite Polarisationsrichtung, der Schritt (1050) des Nachladens des Piezo-Elements ($C_{piezo}$) in die zweite Polarisationsrichtung sowie der Schritt (1060) des Haltens der zweiten Polarisationsrichtung im Piezo-Element ($C_{piezo}$) wiederholt ausgeführt werden.

6. Mikromechanischer Antrieb zum Antreiben einer Vorrichtung, **dadurch gekennzeichnet, dass** der mikromechanische Antrieb eine Schaltung (200) gemäß einem der Ansprüche 1 bis 3 aufweist.

**Claims**

1. Circuit (200) for the bipolar charge recovery of a piezoelectric or electrostatic drive, in which a piezoelectric element ($C_{piezo}$) is connected in series with a coil ($L_{drive}$), wherein a first connection of the piezoelectric element ($C_{piezo}$) is connected to a first switch (S1) and to a second switch (S2), wherein a first connection of the coil ($L_{drive}$) is connected to a third switch (S3) and to a fourth switch (S4), wherein a second connection of the piezoelectric element ($C_{piezo}$) is connected to a second connection of the coil ($L_{drive}$), wherein the first switch (S1) and the third switch (S3) are connected to a first connection of a voltage supply (DC), and wherein the second switch (S2) and the fourth switch (S4) are connected to a second connection of the voltage supply (DC), **characterized in that** the second switch (S2) is connected to a comparator (304) which is designed to determine a Current zero crossing at the second switch (S2), and the fourth switch (S4) is connected to a further comparator (306) which is designed to determine a current zero crossing at the fourth switch (S4), and/or at least one of the switches (S1, S2, S3, S4) is connected to an actuation logic (302) which is designed to determine the current zero crossing at the second switch (S2) and the fourth switch (S4).

2. Circuit (200) according to Claim 1, in which at least one of the switches (S1, S2, S3, S4) is embodied as a semiconductor switch.

3. Circuit (200) according to one of the preceding claims, in which the comparator (304) and/or the further comparator (306) are/is embodied as a switched comparator.

4. Method (1000) for actuating a circuit (200) for the bipolar charge recovery of a piezoelectric or electrostatic drive, wherein the circuit (200) has a piezoelectric element ($C_{piezo}$) with a coil ($L_{drive}$) connected in series to the piezoelectric element ($C_{piezo}$), wherein a first connection of the piezoelectric element ($C_{piezo}$) is connected to a first switch (S1) and to a second switch (S2), wherein a first connection of the coil ($L_{drive}$) is connected to a third switch (S3) and to a fourth switch (S4), wherein a second connection of the piezoelectric element ($C_{piezo}$) is connected to a second connection of the coil ($L_{drive}$), wherein the first switch (S1) and the third switch (S3) are connected to a first connection of a voltage supply (DC), and wherein the second switch (S2) and the fourth switch (S4) are connected to a second connection of the voltage supply (DC), wherein the method (1000) comprises the following steps:

reversing the polarity (1010) of the piezoelectric element ($C_{piezo}$) into a first polarization direction, wherein the second switch (S2) and the fourth switch (S4) are closed, and wherein the first switch (S1) and the third switch (S3) are opened; recharging (1020) the piezoelectric element (Cpiezo) into the first polarization direction, wherein the second switch (S2) is opened and the first switch (S1) is closed, and wherein the third switch (S3) remains open and the fourth switch (S4) remains closed; maintaining (1030) the first polarization direction in the piezoelectric element ($C_{piezo}$) , wherein the first switch (S1) and the fourth switch (S4) are opened, and wherein the second switch (S2) and the third switch (S3) remain open;

reversing the polarity (1040) of the piezoelectric element ($C_{piezo}$) into a second polarization direction, wherein the second switch (S2) and the fourth switch (S4) are closed, and wherein the first switch (S1) and the third switch (S3) remain open;

recharging (1050) the piezoelectric element ($C_{piezo}$) into the second polarization direction, wherein the fourth switch (S4) is opened and the third switch (S3) is closed, and wherein the first switch (S1) remains open and the second switch (S2) remains closed; and

maintaining (1060) the second polarization direction in the piezoelectric element ($C_{piezo}$), wherein the second switch (S2) and the third switch (S3) are opened, and wherein the first switch (S1) and the fourth switch (S4) remain open,

**characterized in that**

the step (1020) of recharging of the piezoelectric element ($C_{piezo}$) into the first polarization direction is carried out after a current zero crossing is detected at the fourth switch (S4) in the step (1010) of the reversing of the polarity of the piezoelectric element ($C_{piezo}$) into the first polarization direction,

in which the step (1030) of maintaining the first polarization direction in the piezoelectric element ($C_{piezo}$) is carried out after a current zero crossing is detected at the fourth switch (S4) in the step (1020) of recharging of the piezoelectric element ($C_{piezo}$) into the first polarization direction,

in which the step (1050) of recharging the piezoelectric element ($C_{piezo}$) into the second polarization direction is carried out after a current zero crossing is detected in the step (1040) of the reversal of the polarity of the piezoelectric element ($C_{piezo}$) into the second polarization direction at the second switch (S2), and

in which the step (1060) of maintaining the second polarization direction in the piezoelectric element ($C_{piezo}$) is carried out after a current zero crossing is detected at the second switch (S2) in the step (1050) of recharging the piezoelectric element ($C_{piezo}$) into the second polarization direction.

5. Method (1000) according to Claim 4, in which the step (1010) of the reversal of polarity of the piezoelectric element ($C_{piezo}$) into the first polarization direction, the step (1020) of recharging the piezoelectric element ($C_{piezo}$) into the first polarization direction, the step (1030) of maintaining the first polarization direction in the piezoelectric element ($C_{piezo}$), the step (1040) of the reversal of polarity of the piezoelectric element ($C_{piezo}$) into the second polarization direction, the step (1050) of recharging the piezoelectric element ($C_{piezo}$) into the second polarization direction and the step (1060) of maintaining the second polarization direction in the piezoelectric element ($C_{piezo}$) are carried out repeatedly.

6. Micromechanical drive for driving a device, **characterized in that** the micromechanical drive has a circuit (200) according to one of Claims 1 to 3.

**Revendications**

1. Circuit (200) de récupération de charge bipolaire d'un mécanisme d'entraînement piézoélectrique ou électrostatique, avec lequel un élément piézoélectrique ($C_{piezo}$) est branché en série avec une bobine ($L_{drive}$), une première borne de l'élément piézoélectrique ($C_{piezo}$) étant reliée à un premier commutateur (S1) et à un deuxième commutateur (S2), une première borne de la bobine ($L_{drive}$) étant reliée à un troisième commutateur (S3) et à un quatrième commutateur (S4), une deuxième borne de l'élément piézoélectrique ($C_{piezo}$) étant reliée à une deuxième borne de la bobine ($L_{drive}$), le premier commutateur (S1) et le troisième commutateur (S3) étant reliés à une première borne d'une alimentation électrique (DC), et le deuxième commutateur (S2) et le quatrième commutateur (S4) étant reliés à une deuxième borne de l'alimentation électrique (DC), **caractérisé en ce que** le deuxième commutateur (S2) est relié à un comparateur (304) qui est configuré pour déterminer un passage par zéro du courant au niveau du deuxième commutateur (S2), et le quatrième commutateur (S4) est relié à un comparateur supplémentaire (306) qui est configuré pour déterminer un passage par zéro du courant au niveau du quatrième commutateur (S4), et/ou au moins l'un des commutateurs (S1, S2, S3, S4) est relié à une logique de commande (302) qui est configurée pour déterminer le passage par zéro du courant au niveau du deuxième commutateur (S2) et du quatrième commutateur (S4).

2. Circuit (200) selon la revendication 1, avec lequel l'au moins l'un des commutateurs (S1, S2, S3, S4) est réalisé sous la forme d'un commutateur à semiconducteur.

3. Circuit (200) selon l'une des revendications précédentes, avec lequel le comparateur (304) et/ou le comparateur supplémentaire (306) sont réalisés sous la forme d'un comparateur commuté.

4. Procédé (1000) de commande d'un circuit (200) de récupération de charge bipolaire d'un mécanisme d'entraînement piézoélectrique ou électrostatique, le circuit (200) possédant un élément piézoélectrique ($C_{piezo}$) avec une bobine ($L_{drive}$) branchée en série avec l'élément piézoélectrique ($C_{piezo}$), une première borne de l'élément piézoélectrique ($C_{piezo}$) étant reliée à un premier commutateur (S1) et à un deuxième commutateur (S2), une première borne de la bobine ($L_{drive}$) étant reliée à un troisième commutateur (S3) et à un quatrième commutateur (S4), une deuxième borne de l'élément piézoélectrique ($C_{piezo}$) étant reliée à une deuxième borne de la bobine ($L_{drive}$), le premier commutateur (S1) et le troisième commutateur (S3) étant reliés à une première borne d'une alimentation électrique (DC), et le deuxième commutateur (S2) et le quatrième commutateur (S4) étant reliés à une deuxième borne de l'alimentation électrique (DC), le procédé (1000) comprenant les étapes suivantes :

inversion de polarité (1010) de l'élément piézoélectrique ($C_{piezo}$) dans un premier sens de polarisation, le deuxième commutateur (S2) et le quatrième commutateur (S4) étant fermés, et le premier commutateur (S1) et le troisième commutateur (S3) étant ouverts ;

recharge (1020) de l'élément piézoélectrique ($C_{piezo}$) dans le premier sens de polarisation, le deuxième commutateur (S2) étant ouvert et le premier commutateur (S1) étant fermé, et le troisième commutateur (S3) restant ouvert et le quatrième commutateur (S4) fermé ;

maintien (1030) du premier sens de polarisation dans l'élément piézoélectrique ($C_{piezo}$), le premier commutateur. (S1) et le quatrième commutateur (S4) étant ouverts, et le deuxième commutateur (S2) et le troisième commutateur (S3) restant ouverts ;

inversion de polarité (1040) de l'élément piézoélectrique ($C_{piezo}$) dans un deuxième sens de polarisation, le deuxième commutateur (S2) et le quatrième commutateur (S4) étant fermés, et le premier commutateur (S1) et le troisième commutateur (S3) restant ouverts ;

recharge (1050) de l'élément piézoélectrique ($C_{piezo}$) dans le deuxième sens de polarisation, le quatrième commutateur (S4) étant ouvert et le troisième commutateur (S3) étant fermé, et le premier commutateur (S1) restant ouvert et le deuxième commutateur (S2) fermé ; et

maintien (1060) du deuxième sens de polarisation dans l'élément piézoélectrique ($C_{piezo}$), le deuxième commutateur (S2) et le troisième commutateur (S3) étant ouverts, et le premier commutateur (S1) et le quatrième commutateur (S4) restant ouverts.

**caractérisé en ce que**
l'étape (1020) de recharge de l'élément piézoélectrique ($C_{piezo}$) dans le premier sens de polarisation est exécutée après qu'un passage par zéro du courant au niveau du quatrième commutateur (S4) soit détecté dans l'étape (1010) d'inversion de polarité de l'élément piézoélectrique ($C_{piezo}$) dans le premier sens de polarisation,

selon lequel l'étape (1030) de maintien du premier sens de polarisation dans l'élément piézoélectrique (Cpiezo) est exécutée après qu'un passage par zéro du courant au niveau du quatrième commutateur (S4) soit détecté dans l'étape (1020) de recharge de l'élément piézoélectrique ($C_{piezo}$) dans le premier sens de polarisation,

selon lequel l'étape (1050) de recharge de l'élément piézoélectrique ($C_{piezo}$) dans le deuxième sens de polarisation est exécutée après qu'un passage par zéro du courant au niveau du deuxième commutateur (S2) soit détecté dans l'étape (1040) d'inversion de polarité de l'élément piézoélectrique ($C_{piezo}$) dans le deuxième sens de polarisation, et

selon lequel l'étape (1060) de maintien du deuxième sens de polarisation dans l'élément piézoélectrique (Cpiezo) est exécutée après qu'un passage par zéro du courant au niveau du deuxième commutateur (S2) soit détecté dans l'étape (1050) de recharge de l'élément piézoélectrique ($C_{piezo}$) dans le deuxième sens de polarisation.

**5.** Procédé (1000) selon la revendication 4, selon lequel l'étape (1010) d'inversion de polarité de l'élément piézoélectrique ($C_{piezo}$) dans un premier sens de polarisation, l'étape (1020) de recharge de l'élément piézoélectrique ($C_{piezo}$) dans le premier sens de polarisation, l'étape (1030) de maintien du premier sens de polarisation dans l'élément piézoélectrique ($C_{piezo}$), l'étape (1040) d'inversion de polarité de l'élément piézoélectrique ($C_{piezo}$) dans le deuxième sens de polarisation, l'étape (1050) de recharge de l'élément piézoélectrique ($C_{piezo}$) dans le deuxième sens de polarisation ainsi que l'étape (1060) de maintien du deuxième sens de polarisation dans l'élément piézoélectrique ($C_{piezo}$) sont exécutées de manière répétitive.

**6.** Mécanisme d'entraînement micromécanique destiné à l'entraînement d'un dispositif, **caractérisé en ce que** le mécanisme d'entraînement micromécanique possède un circuit (200) selon l'une des revendications 1 à 3.

## Fig. 1

+V$_0$

S4

S3　　　D3

L

S2　　　D2

C

S1

-V$_0$

## Fig. 2

200

S1

C$_{piezo}$　　L$_{drive}$

S3

DC

S2

S4

**Fig. 3**

**Fig. 4**

## Fig. 5

## Fig. 6

**Fig. 7**

**Fig. 8**

## Fig. 9

## Fig. 10

# Fig. 11

**Fig. 12**

1200

**Fig. 13**

1300

**IN DER BESCHREIBUNG AUFGEFÜHRTE DOKUMENTE**

**In der Beschreibung aufgeführte Patentdokumente**

•   DE 102010015660 A1


**In der Beschreibung aufgeführte Nicht-Patentliteratur**

•   **D. CAMPOLO.** Efficient Charge Recovery Method for Driving Piezoelectric Actuators with Quasi-Square Waves. *IEEE Transactions on Ultrasonics, Ferroelectrics, and Frequency Control,* 2003, vol. 50 (3), 237-244